# EUROPÄISCHE PATENTSCHRIFT

(11) **EP 2 290 727 B1**
(45) Veröffentlichungstag und Bekanntmachung des Hinweises auf die Patenterteilung: **10.10.2018**
(21) Anmeldenummer: 10173526.4
(22) Anmeldetag: 20.08.2010
(51) Int. Cl.: H01L 51/52

(54) **Lichtemittierende Vorrichtung**
Light emitting device
Dispositif émettant de la lumière

(30) Priorität: 25.08.2009 AT 53009 U
(43) Veröffentlichungstag der Anmeldung: 02.03.2011
(73) Patentinhaber: Zumtobel Lighting GmbH, 6850 Dornbirn (AT)
(72) Erfinder: Gutlederer, Erwin, 3371 Neumarkt (AT)
(74) Vertreter: Thun, Clemens

(56) Entgegenhaltungen:
- WO-A1-2007/107903
- WO-A1-2009/101579
- WO-A2-2008/001241
- WO-A2-2009/074127
- DE-A1-102005 029 431
- US-A1- 2002 050 958
- S REINEKE ET AL.: "White organic light-emitting diodes with fluorescent tube efficiency", NATURE, Bd. 459, 14. Mai 2009 (2009-05-14), Seiten 234-238, XP002635593,

## Beschreibung

Die Erfindung betrifft eine lichtemittierende Vorrichtung gemäß dem Oberbegriff von Anspruch 1.

### Technisches Gebiet

Ein Beispiel für derartige lichtemittierende Vorrichtungen sind organische Leuchtdioden. Organische Leuchtdioden (organic light emitting diode, OLED) sind vielversprechende, aus organischen Halbleitermaterialien aufgebaute Lichtquellen, welche zunehmend für Anwendungen in der Allgemeinbeleuchtung an Bedeutung gewinnen.

Das Interesse an OLEDs begründet sich zum einen mit großen Fortschritten bei der Energieeffizienz dieser Lichtquellen (Lichtausbeute Lumen/Watt), die in den letzten Jahren erzielt werden konnten. So wurde vor kurzem im Labor eine Weißlicht abstrahlende OLED realisiert, deren Effizienz mit der Effizienz einer konventionellen Leuchte mit Leuchtstofflampen vergleichbar ist (S Reineke et al, White organic light-emitting diodes with fluorescent tube efficiency, Nature 459 (2009), p 234). Es wird erwartet, dass die Effizienz von OLEDs aufgrund intensiver Forschungsaktivitäten auf diesem Gebiet zukünftig noch weiter verbessert werden kann.

OLEDs sind zudem interessant, da sie ein flächiges Leuchtmittel mit verhältnismäßig großer Lichtabstrahlfläche darstellen und dadurch neuartige Applikationen ermöglichen. Leuchtdioden aus anorganischen Halbleitermaterialien (LED) (wie beispielsweise aus III-V Verbindungshalbleitern wie GaN), die gegenwärtig den Beleuchtungsmarkt revolutionieren, sind im Gegensatz dazu annähernd punktförmige Lichtquellen und eignen sich aufgrund ihrer stark gebündelten Lichtemission bevorzugt für Strahler und Beleuchtungsspots. Konventionelle Lichtquellen wie Leuchtstoffenlampen sind Leuchtmittel mit linearer, länglicher Ausdehnung. Beide Lichtquellen benötigen daher mehr oder weniger aufwendige Optiken bzw lichtlenkende Elemente, um Leuchten mit (groß)flächiger Lichtabstrahlung zu realisieren.

Leuchtdioden basierend auf organischen Materialien haben das Potential, zukünftig kostengünstiger als Leuchtdioden aus anorganischen Halbleitermaterialien hergestellt zu werden. Der Grund dafür ist, dass OLEDs im Gegensatz zu anorganischen LEDs keinen Aufbau aus einkristallinen Halbleitermaterialien erfordern und daher vergleichsweise einfach großflächig hergestellt werden können.

### Stand der Technik

OLEDs weisen typischerweise eine annähernd Lambert'sche Abstrahlcharakteristik auf. Für Anwendungen in der Allgemeinbeleuchtung wie beispielsweise bei Bürobeleuchtungen ist hingegen häufig eine davon abweichende, gerichtete Abstrahlcharakteristik erwünscht beziehungsweise aufgrund von Normen gefordert. So wird beispielsweise bei Bürobeleuchtungen aufgrund von Normen gefordert, dass der Abstrahlwinkel der Lichtstrahlen begrenzt ist, um eine Blendung des Betrachters zu verhindern.

Neben diesen Normenanforderungen besteht ein lang gehegter Wunsch des Lichtplaners, die Lichtabstrahlcharakteristik einer Leuchte dynamisch variierbar zu gestalten. Die Lichtabstrahlcharakteristik einer Leuchte soll dabei nicht statisch und unveränderlich sein, sondern variierbar sein und an die Anwendung flexibel angepasst werden können.

Zur Veränderung der Lichtabstrahlcharakteristik einer Leuchte sind aus dem Stand der Technik unterschiedliche Technologien bekannt.

In einer konventionellen Leuchte wird das Licht durch eine Lichtquelle erzeugt und ein optisches System (lichtlenkendes System) bestimmt die Lichtabstrahlcharakteristik (Lichtverteilung) der Leuchte. Typischerweise handelt es sich bei dem optischen System um ein oder mehrere Reflektoren, die Licht durch Reflexion lenken. Beim optischen System kann es sich aber auch um lichtlenkende Elemente handeln, die das Licht durch Lichtbrechung (wie beispielsweise bei einer Linse oder einem Prisma), durch Lichtbeugung oder durch Streuung (wie beispielsweise bei einer Streuscheibe) gezielt beeinflussen.

Um nun die Lichtabstrahlcharakteristik einer Leuchte gezielt zu verändern, kann der relative Abstand zwischen Lichtquelle und optischem System variiert werden. Dies geschieht bei einer Taschenlampe oder einer Stirnlampe, bei der eine Linse oder ein Reflektor relativ zu einer Lichtquelle bewegt und verschieden positioniert wird. Je nach Positionierung kann eine eng fokusierte oder breit abstrahlende Lichtverteilung erzielt werden.

Eine alternative Lösung wird in der WO2007/014594 der Anmelderin vorgeschlagen. Bei dieser Lösung bleibt der relative Abstand zwischen der Lichtquelle und dem optischen lichtlenkenden System unverändert, die Lichtquelle wird um das optische System herumbewegt. In der WO2007/014594 wird eine Vorrichtung offenbart, bei der eine stabförmige Lichtquelle um einen länglichen Glasstab geschwenkt wird. Da der Glasstab nicht zylinderförmig ist, sondern in Radialrichtung unterschiedliche Krümmungen aufweist (i.e. keinen kreisförmigen Querschnitt, sondern bspw einen elliptischen Querschnitt aufweist), trifft das Licht bei unterschiedlicher Positionierung der Lichtquelle auf verschiedene Krümmungen des Glasstabs. Da die lichtbrechende Wirkung des Glasstabs von der Krümmung abhängt, kann so die Lichtverteilung gesteuert werden. Eine andere bekannte Technologie sieht vor, dass die Krümmung eines lichtbrechenden Systems wie beispielsweise einer Flüssigkeitslinse adaptierbar ist. Bei einer Flüssigkeitslinse kann dies durch Anlegen einer elektrischen Spannung erzielt werden (electrowetting lenses).

All diesen Lösungen ist gemeinsam, dass sie sich nur in unzureichender Weise auf OLEDs übertragen lassen. Die Vorteile, die ein neuartiges großflächig abstrahlendes Leuchtmittel wie eine OLED bietet, werden durch diese Lösungen nur mangelhaft unterstützt beziehungsweise zur Wirkung gebracht. Bei einigen dieser Lösungen ist zudem nachteilig, dass Teile mechanisch bewegt werden und sich daher im Betrieb abnützen können.

Aus der WO 2009/101579 A1 ist eine Beleuchtungseinrichtung mit einstellbarer Strahlcharakteristik bekannt.

### Technische Aufgabe und Darstellung der Erfindung

Die Aufgabe der Erfindung ist, eine lichtemittierende Vorrichtung der eingangs genannten Art zur Verfügung zu stellen, welche eine alternative Möglichkeit zur gezielten Beeinflussung der Lichtabstrahlcharakteristik aufzeigt. Insbesondere soll die Lichtabstrahlcharakteristik eines flächig abstrahlenden Leuchtmittels auf einfache und effektive Weise gezielt kontrolliert werden können.

Diese Aufgabe wird erfindungsgemäß mit den kennzeichnenden Merkmalen des Patentanspruchs 1 gelöst. Vorteilhafte Weiterbildungen der Erfindung sind in zugehörigen Unteransprüchen beschrieben oder lassen sich aus der nachfolgenden Beschreibung und den Ausführungsbeispielen entnehmen. Ein erfindungsgemäßes Beleuchtungssystem ist Gegenstand von Anspruch 16.

Erfindungsgemäß wird eine lichtemittierende Vorrichtung vorgeschlagen, welche mindestens eine flächig ausgebildete lichtemittierende Schicht mit zwei gegenüberliegenden Oberflächen aufweist, sowie eine flächig ausgebildete transparente erste Elektrode, die die erste Oberfläche der lichtemittierenden Schicht elektrisch kontaktiert, eine flächig ausgebildete zweite Elektrode, die die zweite Oberfläche der lichtemittierenden Schicht elektrisch kontaktiert, und lichtlenkende optische Mittel, die über der von der lichtemittierenden Schicht abgewandten Oberfläche der transparenten ersten Elektrode angeordnet sind. Mindestens eine Elektrode ist in mindestens zwei streifenförmige Teilbereiche strukturiert, welche selektiv mit elektrischer Spannung ansteuerbar sind, wobei die Ansteuerung eines streifenförmigen Teilbereichs der Elektrode Lichtemission in einem zugeordneten Teilbereich der lichtemittierenden Schicht bewirkt, und wobei die lichtlenkenden optischen Mittel strukturiert sind und das Licht aus verschiedenen Teilbereichen der lichtemittierenden Schicht unterschiedlich lenken. Dabei weisen sowohl die Strukturierung der Elektrode in streifenförmige Teilbereiche als auch die Strukturierung der lichtlenkenden optischen Mittel eine Periodizität in zumindest einer Richtung auf.

Die Strukturierung der Elektrode weist eine annähernd gleiche Periodizität auf wie die Strukturierung der lichtlenkenden optischen Mittel.

Des Weiteren ist vorgesehen, dass sich die Strukturierung der lichtlenkenden optischen Mittel über die Fläche der lichtemittierenden Vorrichtung hinweg ändert und dass sich die Strukturierung der Elektrode über die flächige Ausdehnung der lichtemittierenden Vorrichtung ändert.

Beispielsweise wäre es denkbar, dass sich die Abstrahlcharakteristik der lichtlenkenden optischen Mittel in einem Zentral- oder Innenbereich von der Abstrahlcharakteristik in einem Rand- oder Außenbereich unterscheidet. In diesem Fall könnte insbesondere der Außenbereich eine asymmetrische bzw. zur Seite gerichtete Lichtabstrahlcharakteristik aufweisen, um den Umgebungsbereich der lichtemittierenden Vorrichtung aufzuhellen, während hingegen der Innenbereich eher eine symmetrische, insbesondere verhältnismäßig stark gerichtete Abstrahlcharakteristik aufweist.

Erfindungsgemäß kann mindestens eine Elektrode in eine Vielzahl von streifenförmigen Teilbereichen strukturiert sein, wobei die streifenförmigen Teilbereiche in mindestens 2 Gruppen zusammengefasst sind, welche selektiv, insbesondere mit unterschiedlicher Spannung ansteuerbar sind.

Erfindungsgemäß können die lichtlenkenden optischen Mittel durch parallel zueinander verlaufende prismenartige Strukturen, durch halbzylinderförmige Elemente oder durch pyramiden-, halbkugel-, linsen- oder kegelförmige Elemente ausgebildet sein. Die lichtlenkenden optischen Mittel können zumindest in einer Richtung periodisch höhenstrukturiert sein. Erfindungsgemäß können die lichtlenkenden optischen Mittel Bereiche oder Teilbereiche aufweisen, die durch unterschiedliche Brechungszahlen gekennzeichnet sind bzw unterschiedliches Streuverhalten aufweisen.

Die erfindungsgemäße lichtemittierende Vorrichtung wird bevorzugt für Beleuchtungsanwendungen eingesetzt. Die lichtemittierende Schicht kann daher vorzugsweise weißes Licht abstrahlen.

Teil der Erfindung ist auch ein Beleuchtungssystem, welches mindestens eine oben genannte lichtemittierende Vorrichtung aufweist.

Der Erfindungsgedanke sei an dieser Stelle kurz zusammengefasst. Sind optisch aktive Materialien über die Fläche der lichtemittierenden Schicht homogen verteilt und weisen die flächigen Elektroden keine unabhängig ansteuerbare Unterteilungen auf, so erfolgt die Lichtemission über die Fläche der lichtemittierenden Schicht annähernd homogen. Kerngedanke der Erfindung ist nun, dass die Lichtemission über die Fläche der lichtemittierenden Schicht inhomogen erfolgt und gezielt elektronisch variier- und steuerbar ist. Durch eine über die Fläche der lichtemittierenden Schicht steuerbare Lichtemission wird bezweckt, dass Licht aus unterschiedlichen Bereichen mit unterschiedlicher Intensität auf die darüber angeordneten lichtlenkenden optischen Mittel trifft. Ist nun die Wirkung der lichtlenkenden optischen Mittel davon abhängig, von wo bzw. unter welchem Winkel Licht auf die lichtlenkenden optischen Mittel fällt, so kann durch Steuerung der Lichtemissionsflächen der lichtemittierenden Schicht die Lichtabstrahlungscharakteristik der lichtemittierenden Vorrichtung gesteuert werden. Eine inhomogene Lichtemission über die Fläche der lichtemittierenden Schicht kann erfindungsgemäß durch eine Strukturierung in Teilbereiche von mindestens einer Elektrode erzielt werden. Bevorzugt soll die Strukturierung der Elektrode so sein, sodass sie von einem Betrachter in normalem Abstand visuell nicht wahrgenommen wird. D.h., aufgrund der Periodizität der Strukturierung der Elektrode in Teilbereiche besteht die Möglichkeit, durch eine entsprechende Ansteuerung der ElektrodenTeilbereiche die Lichtabstrahlung der Vorrichtung zu verändern, wobei für einen Betrachter trotz allem über die im Wesentlichen gesamte Fläche der lichtemittierenden Vorrichtung hinweg Licht abgegeben wird.

Die physikalische Wirkung der lichtlenkenden optischen Mittel kann unter anderem auf Lichtbrechung, Lichtbeugung oder Streuung beruhen. Das Licht kann beispielsweise durch die lichtbrechende Wirkung von Prismen oder linsenförmigen Elemente gelenkt werden. Bei Lichtbeugung wird Licht mittels Elementen, die Strukturen in der Größenordnung der Wellenlänge des emittierten Lichts aufweisen, gelenkt. Lichtlenkung durch Streuung kann beispielsweise mittels einer Streuplatte, vorzugsweise mit abschnittsweiser anisotroper Streucharakteristik, realisiert werden. Es sind auch lichtlenkende optische Mittel denkbar, bei denen unterschiedliche physikalische Wirkungen kombiniert sind, beispielsweise sowohl Lichtstreuung als auch Lichtbrechung genützt werden.

Nachfolgend wird die Erfindung anhand von vorteilhaften Ausgestaltungen und vereinfachten Zeichnungen näher erläutert. Es zeigen:
Abb 1 einen schematischen Aufbau einer OLED gemäß dem Stand der Technik;
Abb 2 exemplarisch unterschiedliche Lichtverteilungskurven;
Abb 3 bis Abb 10 verschiedene, besonders vorteilhafte Ausführungsbeispiele der Erfindung.

Dabei sind unterschiedliche Ausführungsbeispiele mit unterschiedlichen Bezugskennzeichen gekennzeichnet, gleiche oder vergleichbare Elemente sind zur besseren Veranschaulichung mit gleichen Bezugskennzeichen gekennzeichnet.

Zusätzlich ist anzumerken, dass zum besseren Verständnis der Erfindung nachfolgend sowohl Ausführungsbeispiele erläutert sind, bei denen die Strukturierung der lichtlenkenden optischen Mittel über die Fläche der lichtemittierenden Vorrichtung hinweg gleichförmig ist, als auch Ausführungsbeispiele erläutert sind, bei denen die Strukturierung der lichtlenkenden optischen Mittel sich über die Fläche der lichtemittierenden Vorrichtung hinweg ändert. Erfindungsgemäß entsprechend den Ansprüchen sind jedoch lediglich die Ausführungsbeispiele, bei denen sich die Strukturierung der lichtlenkenden optischen Mittel über die Fläche der lichtemittierenden Vorrichtung hinweg ändert und sich die Strukturierung der Elektrode über die flächige Ausdehnung der lichtemittierenden Vorrichtung ändert.

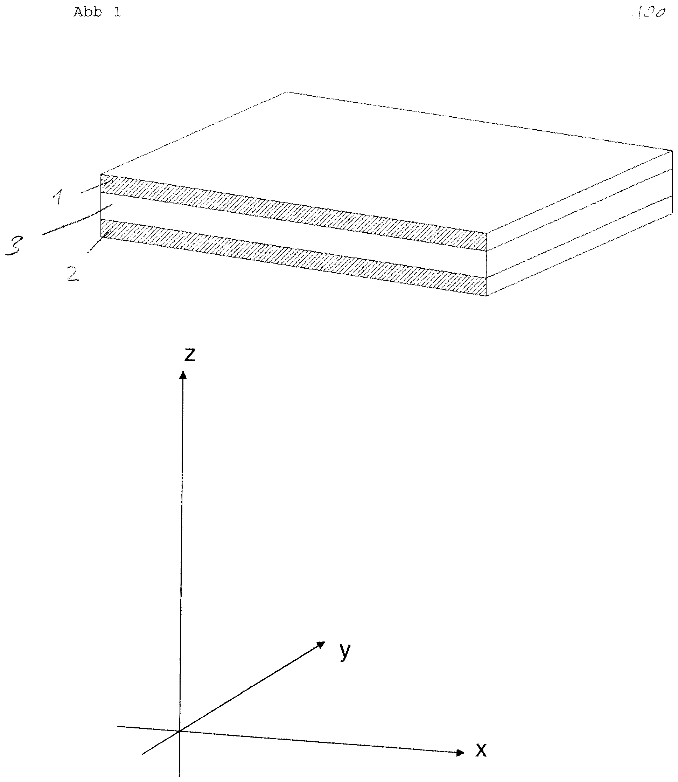

In Abb 1 soll der grundsätzliche Aufbau und die Funktionsweise einer OLED, wie sie aus dem Stand der Technik bekannt ist, kurz skizziert werden.

Es sei zuerst das im Folgenden verwendete Koordinatensystem definiert. Die xy-Ebene des Koordinatensystems ist durch die flächige Ausdehnung der lichtemittierenden Vorrichtung gegeben, die z-Achse ist orthogonal zur xy-Ebene.

Abb 1 zeigt einen Querschnitt durch die perspektivische Darstellung einer bekannten OLED 100. Typischerweise haben OLEDs einen schichtförmigen Aufbau: Zwischen einer ersten Elektrode 1 und einer zweiten Elektrode 2, die flächig ausgebildet sind, sind eine oder mehrere dünne Schichten aus organischen, halbleitenden Materialien angeordnet. Bei Anlegen einer elektrischen Spannung werden elektrische Ladungsträger (Elektronen von der einen Elektrode, Löcher von der anderen Elektrode) in die lichtemittierende Schicht 3 injiziert. Elektronen und Löcher driften aufgrund des extern angelegten elektrischen Felds aufeinander zu und können einen gebundenen Zustand (Elektron-Loch-Paar, auch Exziton genannt) bilden. Bei der Rekombination eines Exzitons wird Energie frei. Diese kann direkt als Lichtphoton emittiert werden oder zur Anregung eines dem Exziton benachbarten, in der lichtemittierenden Schicht 3 angeordneten optisch aktiven Farbstoffmoleküls führen. Das Farbstoffmolekül ist so gewählt, dass die Relaxation des Farbstoffmoleküls in den Grundzustand möglichst unter Aussendung eines Photons innerhalb eines gewünschten Wellenlängenbereichs erfolgt. Die Dicke einer OLED in z-Richtung ist im Vergleich zur Ausdehnung in die x- und y-Richtung sehr gering. Typischerweise liegt die Dicke der lichtemittierenden Schicht(en) in der Größenordnung von mehreren 10 bis mehreren 100 Nanometern, wohingegen die Ausdehnung in die x- und y-Richtung mehrere Zentimeter oder Dezimeter betragen kann.

Um Effizienz, Lebensdauer beziehungsweise Betriebsspannung einer OLED zu optimieren, ist in der Praxis der Aufbau einer OLED typischerweise komplexer. So können zusätzliche organische Schichten vorgesehen sein, um die Injektion der Ladungsträger aus den Elektroden in die lichtemittierende Schicht 3 zu erleichtern (sogenannte electron injection layer und hole injection layer, jeweils zwischen der ersten Elektrode 1 und der lichtemittierenden Schicht 3 und zwischen der zweiten Elektrode 2 und der lichtemittierenden Schicht 3 angeordnet). Ebenso können zusätzliche organische Schichten vorgesehen sein, die den Transport der Ladungsträger unterstützen (sogenannte electron transport layer (ETL) und hole transport layer (HTL)). Diese zusätzlichen Schichten sind in der Abb 1 nicht dargestellt. Nähere Details dazu können beispielsweise der US 2006/0232194 entnommen werden.

Zumindest eine der beiden Elektroden ist zumindest teilweise lichtdurchlässig im optischen Wellenlängenbereich ausgebildet. Durch die lichtdurchlässige Elektrode, in Abb 1 mit 1 als erste Elektrode bezeichnet, kann das in der lichtemittierenden Schicht 3 erzeugte Licht aus der OLED austreten, im hier gezeigten Beispiel weist die Lichtaustrittsfläche der OLED nach oben. Die lichtdurchlässige Elektrode kann beispielsweise aus Indium-Zinn-Oxid (ITO) oder aus undotiertem oder beispielsweise mit Aluminium dotiertem Zink-Oxid (ZAO) gefertigt werden. Die andere, gegenüberliegende zweite Elektrode 2 muss nicht transparent sein und kann aus einem Metall wie beispielsweise Aluminium oder einer Metalllegierung gebildet werden. Um eine höhere Effizienz zu erzielen, ist diese zweite Elektrode 2 bevorzugt reflektierend im optischen Bereich ausgebildet. Die Austrittsarbeit der Elektrodenmaterialien soll so gewählt werden, dass Elektronen bzw Löcher leicht von den jeweiligen Elektroden in die organische (n) Schicht (en) eindringen können.

Als optisch aktives, strahlungserzeugendes organisches Material können verschiedene Materalien verwendet werden. Derzeit gebräuchlich und kommerziell erhältlich sind organische Materalien mit geringem Molekulargewicht (auch kleinmoleküliges organisches Material, small-molecule OLED), Polymere (polymere OLED) oder eine Kombination dieser Materialien.

Kleinmolekülige organische Materalien werden typischerweise unter Vakuumbedingungen aus der Gasphase aufgebracht (organic vapour phase deposition). Ein Beispiel für lichtemittierende kleinmolekülige organische Materialien sind Metall-Chelatkomplexe wie Tris(8-hydroxyquinolinato)aluminium (Alq3). Es kann sich aber auch um andere geeignete optisch aktive Moleküle wie bspw optisch aktive Oligomere oder Dendrimere handeln. Beispiele für eine OLED aus kleinmoleküligen organischen Materalien sind in WO03/107452, US6097147 oder US 2006/0232194 angegeben.

Polymere werden typischerweise aus einer flüssigen Lösung aufgebracht, beispielsweise durch ein Aufschleuderverfahren (Spincoating) oder durch räumlich selektives Abscheiden mittels eines Druckverfahrens (Rolle-zu-Rolle Verfahren oder

Tintenstrahldruckverfahren). Beispiele für lichtemittierende Polymere sind Poly(pPhenylenvinylen) (PPV) oder Polymere auf Basis von Polyfluoren oder Spirofluorine. Beispiele für eine OLED aus Polymeren sind aus EP0423283, WO 2009/093033, und WO 2009/066061 bekannt.

Es sei angemerkt, dass der detaillierte Aufbau der OLED für die Erfindung nicht von relevanter Bedeutung ist. Die Erfindung kann grundsätzlich für beliebig elektroluminiszierende Leuchtmittel mit flächiger Ausdehnung und Abstrahlung angewandt werden, bei denen eine elektrolumineszierende Substanz zwischen zwei flächigen Elektroden angeordnet ist. Ein Beispiel dafür sind lichtemittierende-elektrochemische-Zellen (light-emitting electrochemical cells LECs) (H Bolink et al, Long-Living Light-Emitting Electrochemical Cells - Control through Supramolecular Interactions, Advanced Materials 20 (2008), p 3910).

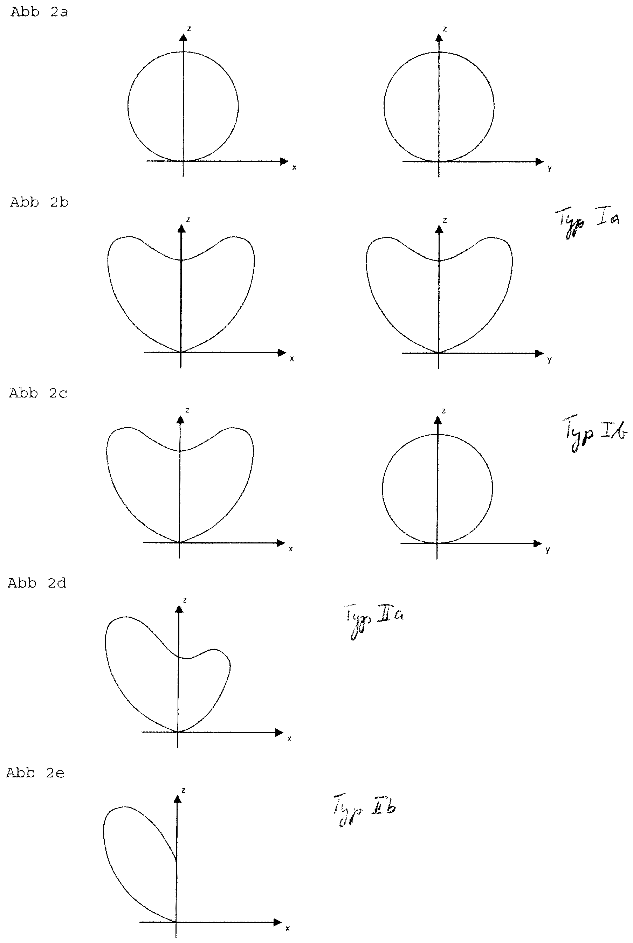

Um die Lichtabstrahlcharakteristik einer Leuchte zu quantifizieren, verwendet man Lichtverteilungskurven. In Abb 2a-2e sind unterschiedliche Lichtverteilungskurven dargestellt, welche die winkelabhängige Verteilung der Lichtstärke angeben. Die in Abb 1 vorgestellte OLED hat eine annähernd Lambertsche Lichtabstrahlcharakteristik in z-Richtung, ihre kreisförmige Lichtverteilungskurve ist in Abb 2a dargestellt. Für Beleuchtungsanwendungen ist häufig eine davon abweichende Lichtverteilungskurve erwünscht. Die vorliegende Erfindung ermöglicht nun, im Betrieb und ausschließlich auf elektronischem Wege die Lichtabstrahlcharakteristik zu variieren. Das Umschalten zwischen verschiedenen Lichtverteilungskurven ist sehr rasch möglich und im Wesentlichen nur durch die Ansprechzeit des Leuchtmittels begrenzt. Ein Wechsel zwischen den verschiedenen Lichtverteilungskurven kann prinzipiell auf einer Zeitskala in der Größenordnung von mehreren Millisekunden erfolgen.

Die in Abb 2b beziehungsweise Abb 2c dargestellten Lichtverteilungskurven, Typ Ia und Typ Ib, sind symmetrisch und weisen zwei Maxima sowohl in x- als auch in y-Richtung (Typ Ia) oder in eine der beiden Richtungen (Typ Ib) auf. Derartige Lichtverteilungen sind geeignet, um eine homogene und gleichmäßige Be- und Ausleuchtung einer von der Lichtquelle entfernten, zur xy-Ebene parallelen Fläche (bspw eines Arbeitsplatzes) zu ermöglichen.

Die in Abb 2d und Abb 2e gezeigten Lichtverteilungskurven, Typ IIa und Typ IIb, zeichnen sich durch eine zumindest in einer Richtung mehr oder weniger ausgeprägte Asymmetrie auf. Eine asymmetrische Lichtabstrahlung ist beispielsweise zur Be- und Ausleuchtung einer Fläche normal zur xy-Ebene (bspw von einer Wandfläche) notwendig. Eine asymmetrische Lichtverteilung kann auch zur Entblendung in eine Richtung dienen.

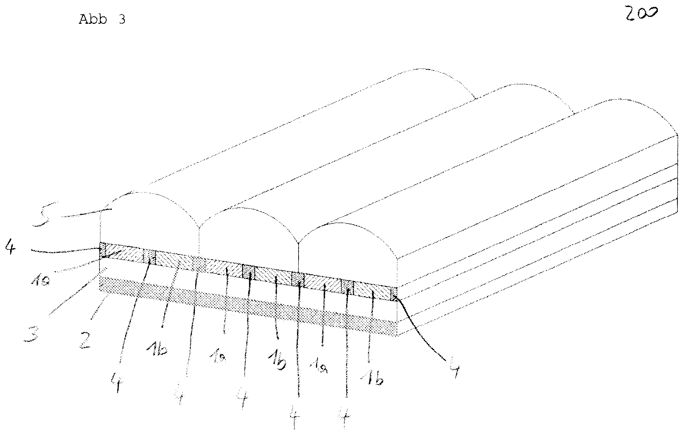

In Abb 3 ist ein erstes Ausführungsbeispiel der erfindundungsgemäßen lichtemittierenden Vorrichtung dargestellt. Es zeigt Abb 3a einen Querschnitt der lichtemittierenden Vorrichtung 200.

Im Unterschied zu der OLED nach Stand der Technik ist eine Elektrode in eine Vielzahl von streifenförmigen Teilbereichen 1a, 1b unterteilt bzw. strukturiert. In der dargestellten Abbildung ist dies die Elektrode, die auf der den lichtlenkenden optischen Mitteln zugewandten Seite der lichtemittierenden Schicht angeordnet ist. Alternativ oder zusätzlich kann bei diesem und allen anderen Ausführungsbeispielen die Elektrode, die auf der den lichtlenkenden optischen Mitteln abgewandten Seite der lichtemittierenden Schicht angeordnet ist, in Teilbereiche strukturiert sein.

Die streifenförmigen Teilbereiche la,lb sind elektrisch voneinander isoliert. Die Teilbereiche sind jeweils durch isolierende Bereiche 4 voneinander getrennt und sind selektiv mit elektrischer Spannung versorgbar.

Damit sich nun in der lichtemittierenden Schicht 3 Exzitonen bilden können und Licht abgestrahlt wird, müssen elektrische Ladungsträger von den gegenüberliegenden Elektroden in die lichtemittierende Schicht injiziert werden. Die Injektion von elektrischen Ladungsträgern erfolgt durch ein zwischen den Elektroden angelegtes elektrisches Feld. Da die mittlere Diffusionslänge der Exzitonen sehr gering ist, kommt es innerhalb der lichtemittierenden Schicht 3 bevorzugt in jenem geometrischen Teilbereich zwischen zwei Elektroden, zwischen denen eine elektrische Spannung (Potentialdifferenz) anliegt, zu Lichtemission. Die Ansteuerung eines Teilbereichs einer Elektrode bewirkt daher Lichtemission in einem dem Teilbereich der Elektrode zugeordneten Teilbereich der lichtemittierenden Schicht.

Durch die Strukturierung der Elektrode in Teilbereiche und selektive Ansteuerung dieser Teilbereiche kann somit innerhalb der lichtemittierenden Schicht eine über die Fläche der lichtemittierenden Vorrichtung inhomogene Lichtemission erzielt werden.

Die lichtlenkenden optischen Mittel 5 können durch jedes geeignete Material gefertigt sein, welches im optischen Wellenlängenbereich, insbesondere im Wellenlängenbereich des von der lichtemittierenden Schicht emittierten Lichts durchlässig ist, beispielsweise aus Glas oder aus einem Polymermaterial wie PMMA (Polymethylmethacrylate). Bevorzugt sind die optischen Mittel einteilig ausgebildet. In vorteilhafter Weise werden sie durch eine Polymerfolie gebildet, welche in kosteneffizienter Weise durch ein Spritzguss- oder Prägeverfahren hergestellt werden kann.

Die lichtlenkenden optischen Mittel 5 weisen eine geeignete Höhenstrukturierung (Strukturierung in z-Richtung) auf. Im hier gezeigten Ausführungsbeispiel sind die lichtlenkenden optischen Mittel aus halbzylinderförmigen Elementen gebildet. Die Längsachse der Halbzylinder ist in y-Richtung parallel zu den Elektrodenstreifen angeordnet. In x-Richtung sind die Halbzylinder derart positioniert, dass eine Halbzylinderform jeweils genau zwei streifenförmige Teilbereiche 1a, 1b der ersten Elektrode 1 geometrisch abdeckt.

Es sind eine Vielzahl von halbzylinderförmigen Elementen in x-Richtung in regelmäßigen Abständen aneinandergereiht. In diesem Sinne weist die Höhenstrukturierung (in z-Richtung) der lichtlenkenden optischen Mittel eine Periodizität in x-Richtung auf.

Die Höhenstrukturierung der lichtlenkenden optischen Mittel bewirkt, dass die lichtbrechende Wirkung der lichtlenkenden optischen Mittel ortsabhängig ist.

Wie im Folgenden näher erklärt wird, kann die Lichtabstrahlcharakteristik der lichtemittierenden Vorrichtung variiert werden, indem mittels geeigneter Ansteuerung der Elektrodenteilbereiche die Lichtemission der lichtemittierenden Schicht ortsabhängig gestaltet wird.

Die strukturierte Elektrode ist abwechselnd in streifenförmige Teilbereiche 1a und streifenförmige Teilbereiche 1b unterteilt. Die streifenförmigen Teilbereiche 1a sind jeweils von streifenförmigen Teilbereichen 1b benachbart und umgekehrt, i.e. streifenförmige Teilbereiche 1b sind jeweils von streifenförmigen Teilbereichen 1a benachbart. Die streifenförmigen Teilbereiche 1a, 1b sind in alternierender Weise in mindestens zwei Gruppen zusammengefasst, die jeweils gemeinsam angesteuert werden. Dies bedeutet, dass die streifenförmigen Teilbereiche 1a jeweils mit gleicher Spannung versorgt werden und getrennt davon die streifenförmigen Teilbereiche 1b jeweils mit einer gemeinsamen Spannung versorgt werden.

Fasst man gedanklich einen streifenförmigen Teilbereich 1a und einen benachbarten streifenförmigen Teilbereich 1b als eine Einheit zusammen, so wiederholt sich diese Einheit periodisch in x-Richtung. In diesem Sinne weist die Strukturierung der Elektrode in Teilbereiche eine Periodizität in x-Richtung auf.

Fasst man nun gedanklich einen streifenförmigen Teilbereich 1a und einen benachbarten streifenförmigen Teilbereich 1b und die darüber angeordneten optischen Mittel als eine Einheit zusammen, so wiederholt sich diese Einheit in einer Richtung periodisch über die lichtemittierende Vorrichtung und bildet einen 1-dim array. In diesem Sinne weist die Strukturierung der Elektrode eine annähernd gleiche Periodizität auf wie die Strukturierung der lichtlenkenden optischen Mittel.

Werden nun die streifenförmigen Teilbereiche 1a angesteuert, wird überwiegend Licht innerhalb der lichtemittierenden Schicht im geometrischen Bereich unterhalb der streifenförmigen Teilbereiche 1a abgestrahlt. Dieses Licht wird nun aufgrund der ortsabhängigen (in x-Richtung) Krümmung der Halbzylinderform anders beeinflusst als Licht, das bei Ansteuerung von streifenförmigen Teilbereichen 1b innerhalb der lichtemittierenden Schicht im geometrischen Bereich unterhalb der streifenförmigen Teilbereiche 1b emittiert wird. Durch Steuerung der Lichtemission in der lichtemittierenden Schicht können also unterschiedliche Lichtverteilungskurven wie bspw jene, die in Abb 2 vorgestellt wurden, realisiert werden. Betrachtet man allerdings die Vorrichtung als Ganzes bzw. zumindest über einen größeren Bereich hinweg, so erfolgt unabhängig davon, wie die streifenförmigen Teilbereiche 1a, 1b angesteuert werden, eine Lichtabgabe über die gesamte Fläche hinweg. Wie später noch näher erläutert wird, sind nämlich vorzugsweise die Dimensionen der Elektrodenteilbereiche derart, dass die Bereiche einzeln für einen Betrachter nicht wahrnehmbar sind. D.h., auch wenn lediglich die streifenförmigen Teilbereiche 1a angesteuert werden und dementsprechend lediglich über jeden zweiten Streifen Licht abgegeben wird, so erscheint dennoch die Anordnung insgesamt als gleichmäßig lichtabstrahlende Fläche. Dieser Eindruck wird auch bei einem Wechsel der Lichtabstrahlcharakteristik beibehalten.

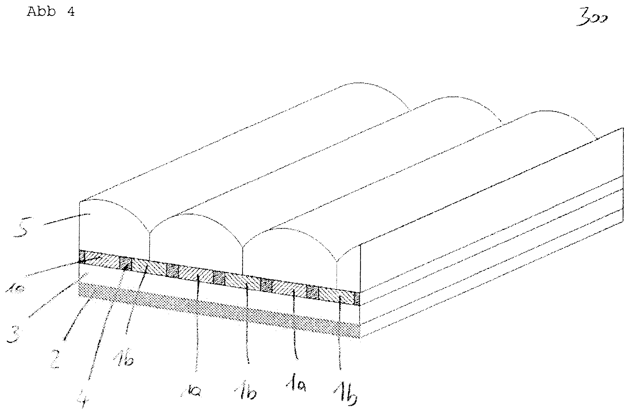

Die Form der lichtlenkenden optischen Mittel, ihre Anordnung, die Strukturierung einer Elektrode und ihre Ansteuerung ist nicht auf das konkrete Ausführungsbeispiel von Abb 3 beschränkt. Es sind unzählige Varianten denkbar, in denen eine Strukturierung der Elektrode mit der Strukturierung der lichtlenkenden optischen Mittel abgestimmt sein kann. In Abb 4-10 sind einige erfindungsgemäße vorteilhafte Ausführungen der Erfindung dargestellt.

Abb 4 zeigt eine erfindungsgemäße lichtemittierende Vorrichtung 300, bei der die lichtlenkenden optischen Mittel 5 als halbzylinderförmige Strukturen ausgebildet sind. Im Gegensatz zu Abb 3 sind die lichtlenkenden optischen Mittel relativ zu den Elektrodenteilbereichen verschoben angeordnet, i.e. ein halbzylinderförmiges Element deckt nicht genau zwei streifenförmige Teilbereiche 1a, 1b ab. Die Halbzylinderform ist mittig über einen streifenförmigen Teilbereich 1a positioniert. Der streifenförmige Teilbereich 1b wird jeweils von zwei benachbarten Halbzylinderformen abgedeckt.

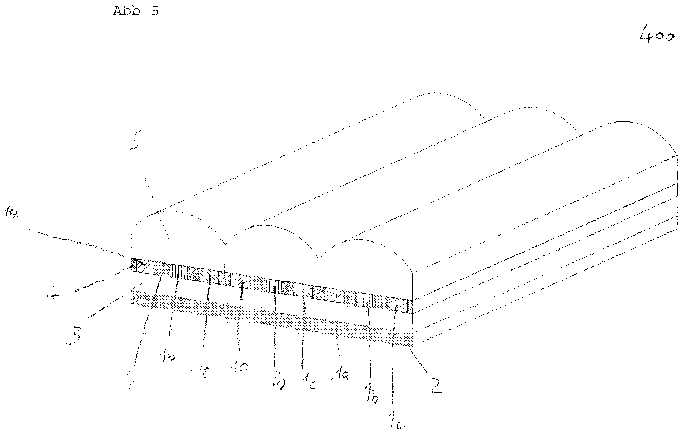

In dem vorteilhaften Ausführungsbeispiel der lichtemittierenden Vorrichtung 400 von Abb 5 weist die Elektrode eine feinere Strukturierung auf als die lichtlenkenden halbzylinderförmigen Elemente. Eine Elektrode ist dabei in mehrere unterschiedliche streifenförmige Teilbereiche 1a, 1b, 1c unterteilt, welche jeweils getrennt voneinander angesteuert werden können. Die Strukturierung der Elektrode ist auch insofern feiner, dass unterhalb eines halbzylinderförmigen Elements mehr als zwei Elektrodenteilbereiche angeordnet sind.

Es sind auch Ausführungsbeispiele denkbar, bei denen umgekehrt die lichtlenkenden Elemente eine feinere Strukturierung aufweisen.

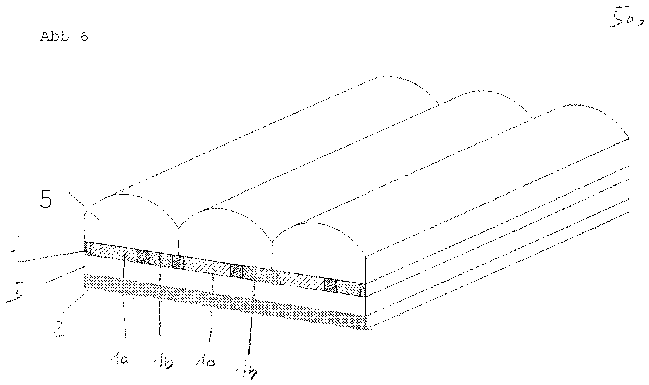

In Abb 6 ist ein vorteilhaftes Ausführungsbeispiel der lichtemittierenden Vorrichtung 500 dargestellt, bei der die Flächen der streifenförmigen Teilbereiche 1a, 1b unterschiedlich groß sind.

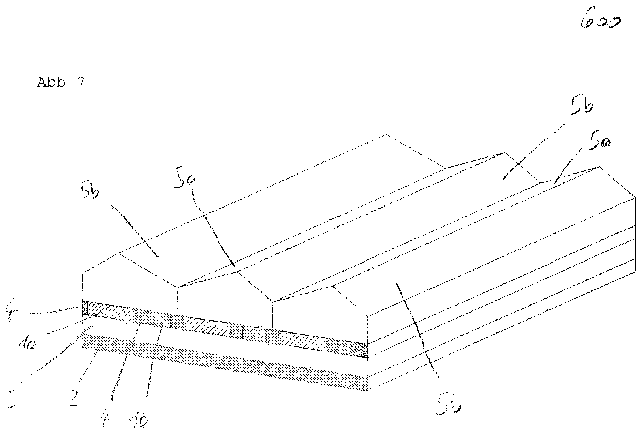

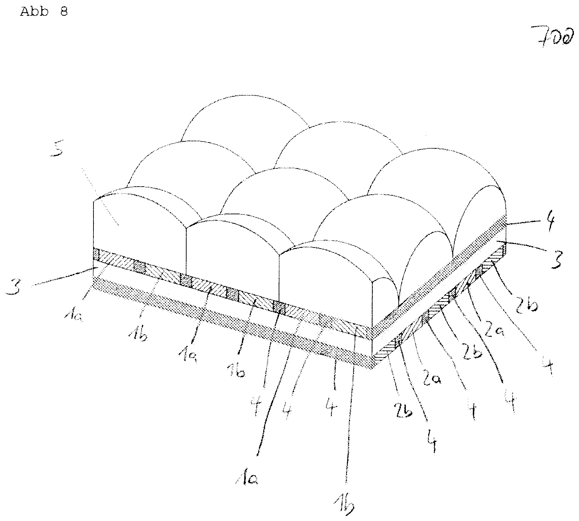

Neben den halbzylinderförmigen Elementen sind alternative Ausgestaltungen der lichtlenkenden optischen Mittel denkbar. So kann es sich bei den lichtlenkenden optischen Mittel um eine Aneinanderreihung von prismenartigen Strukturen in einem 1-dim array (wie bspw in Abb 7) oder Strukturen (pyramiden-, kegel-, oder halbkugelförmig), welche in einem 2 dim array angeordnet sind (wie bspw in Abb 8), handeln. Die Lichtlenkung basiert dabei auf Lichtbrechung.

Abb 7 zeigt eine lichtemittierende Vorrichtung 600 mit prismenartigen Strukturen, die an der von der Elektrode abgewandten Seite planare Lichtaustrittsflächen 5a, 5b aufweisen, die außerhalb der xy-Ebene liegen und alternierend zueinander geneigt sind. Die Lichtaustrittsfläche weist im Wesentlichen plane Flächen auf, die Höhenstrukturierung der lichtlenkenden optischen Mittel ist daher in einer Richtung (x-Richtung) linear steigend und fallend. Die hier gezeigte Variante ist asymmetrisch, d.h., die Lichtaustrittsflächen 5a und 5b sind unterschiedlich groß. Es sind natürlich auch symmetrische Formen mit gleich großen Lichtaustrittsflächen 5a, 5b denkbar. In einem vorteilhaften Ausführungsbeispiel können die lichtlenkenden optischen Mittel neben planaren Lichtaustrittsflächen auch beliebig gekrümmte Oberflächen aufweisen. Die Höhenstrukturierung der lichtlenkenden optischen Mittel ist dabei in einer Richtung zumindest teilweise gerundet.

Abb 8 zeigt eine lichtemittierende Vorrichtung 700 mit halbkugelförmigen Strukturen bzw. Elementen, die periodisch in x und y-Richtung angeordnet sind und dabei ein 2-dim array bilden. In Abb 8 sind beide Elektroden in streifenförmige Teilbereiche la,lb bzw. 2a,2b strukturiert. Die streifenförmigen Teilbereiche la,lb der ersten Elektrode, die auf der den lichtlenkenden optischen Mitteln zugewandten Seite der lichtemittierenden Schicht angeordnet sind, sind dabei um 90° verdreht zu den streifenförmigen Teilbereichen 2a, 2b der zweiten Elektrode, die auf der den lichtlenkenden optischen Mitteln abgewandten Seite der lichtemittierenden Schicht angeordnet sind, angeordnet. Die Elektrodenteilbereiche sind dabei zur Ansteuerung alternierend in Gruppen zusammengefasst ((1a, 1b) bzw (2a, 2b)). Durch die 2dim Strukturierung (in x- und y-Richtung) wird eine steuerbare Lichtlenkung in zwei Richtungen ermöglicht, wohingegen bei 1dim array Strukturen (wie in Abb 3 bis Abb 7) eine Änderung der Lichtabstrahlcharakteristik nur in eine Richtung möglich ist.

Bevorzugt liegt die Breite der länglichen halbzylinderförmigen Elemente in x-Richtung bzw. die Breite in x-Richtung und Länge in y-Richtung der pyramiden- oder kegelförmigen Strukturen und die Strukturierung der Elektroden in mikroskopischen Größenordnungen. Für einen Betrachter aus einem normalen Abstand sollte die Strukturierung der lichtemittierenden Vorrichtung nicht sichtbar sein. Typischerweise ist die Breite der halbzylinderförmigen Elemente größer als die Wellenlänge des emittierten Lichts, damit sich Beugungseffekte nicht bemerkbar machen.

In vorteilhafter Weise können die lichtlenkenden optischen Mittel neben lichtlenkenden Effekten die Auskopplung des Lichts unterstützen. Die Auskopplung von Licht aus einem optisch dichteren Material (Material mit höherem Brechungsindex), wie beispielsweise aus einem Halbleitermaterial, ist insofern schwierig und technologisch herausfordernd, da ein Teil des Lichts an der Grenzfläche totalreflektiert wird.

Grundsätzlich kann an einer planaren Grenzfläche zwischen zwei Materialien mit verschiedenen optischen Brechungsindices Licht aus dem optisch dichteren Medium nur unter einem Lichtkegel mit einem Öffnungswinkel delta <= arcsin (n2/n1) austreten, wobei n1 der Brechungsindex des optisch dichteren Materials und n2 der Brechungsindex des optisch dünneren Materials ist. Lichtstrahlen aus dem optisch dichteren Material, die unter einem größeren Winkel auf die planare Grenzfläche treffen, werden ins optisch dichtere Medium zurückreflektiert (totalreflektiert).

Ist nun die Grenzfläche keine planare Fläche, sondern in einer Richtung normal zur flächigen Ausdehnung der lichtemittierenden Schicht höhenstrukturiert (wie bspw bei prismen-, pyramiden-, und kegelförmigen Elementen), so kann die Lichtauskopplung entscheidend verbessert werden.

Durch geeignete Ansteuerung der streifenförmigen Teilbereiche la,lb bzw 2a,2b können sowohl asymmetrische als auch symmetrische Lichtverteilungskurven wie in Abb 2a-e erzielt werden und zwischen diesen umgeschaltet werden. Die Umschaltung zwischen verschiedenen Lichtverteilungskurven kann in kontinuierlicher oder diskreter Weise erfolgen, indem die Lichtemission in den jeweiligen Teilbereichen der lichtemittierenden Schicht in kontinuierlicher oder diskreter Weise variiert wird. Die Lichtemission in einem einem Elektrodenteilbereich zugeordneten Teilbereich der lichtemittierenden Schicht wird durch Anlegen einer Spannung an den jeweiligen Elektrodenteilbereich kontrolliert. Die Lichtverteilungskurve der erfindungsgemäßen Leuchte kann beispielsweise verändert werden, indem die Spannung an den streifenförmigen Teilbereiche 1a erhöht (bzw erniedrigt) wird, während gleichzeitig die Spannung an den streifenförmigen Teilbereiche 1b erniedrigt (bzw erhöht) wird. Eine asymmetrische ausgeprägte Abstrahlung (Typ IIa oder IIb) wird dann erreicht, wenn die Leistungszufuhr an beide Elektrodenteilbereichen möglichst unterschiedlich ist, i.e. streifenförmige Teilbereiche 1a werden mit niedriger bis keiner Spannung (niedrige Lichtemission) betrieben, während die anderen streifenförmigen Teilbereiche 1b mit maximaler Spannung (hohe Lichtemission) betrieben werden. Eine Asymmetrie der Lichtverteilung wird verstärkt (Typ IIb), wenn die lichtlenkenden optischen Mittel wie bspw in Abb 7 eine zusätzliche Asymmetrie aufweisen.

Sind hingegen die lichtlenkenden optischen Mittel symmetrisch in x-Richtung ausgebildet und werden beide (gleich großen) streifenförmigen Teilbereiche 1a, 1b mit gleicher Spannung betrieben, so erfolgt die Lichtabstrahlung bevorzugt gemäß symmetrischen Lichtverteilungskurven (Typ Ia und Ib).

Den bisherigen Ausführungsbeispielen ist gemeinsam, dass sowohl die lichtlenkenden optischen Mittel als auch zumindest eine Elektrode eine in einer oder zwei Richtungen periodisch wiederkehrende Strukturierung aufweisen. Die Periodizität der lichtlenkenden optischen Mittel ist dabei an die Periodizität der Elektrodenstrukturierung (Unterteilung in Teilbereiche) angepasst. Die Strukturierung ist gleichförmig über die Fläche der lichtemittierenden Vorrichtung. In diesem Fall kann wie zuvor erläutert die Lichtabstrahlcharakteristik durch unterschiedliches Ansteuern der Elektrodenteilbereiche verändert werden, insgesamt gesehen ergibt sich allerdings für einen Betrachter der Eindruck einer gleichmäßig leuchtenden Fläche. Diese Ausführungsbeispiele gehören jedoch nicht zur beanspruchten Erfindung.

Teil der beanspruchten Erfindung ist die Ausführungsform der bisherigen Ausführungsbeispiele in der über die Fläche der lichtemittierenden Vorrichtung sich die Strukturierung von sowohl den lichtlenkenden optischen Mitteln als auch der zumindest einen Elektrode variiert. So ist beispielsweise denkbar, dass die Lichtabstrahlfläche der lichtemittierenden Vorrichtung in einen Innen- und einen Randbereich unterteilt ist, wobei der Innenbereich eine unterschiedliche Abstrahlcharakteristik als der Randbereich aufweist. Eine unterschiedliche Abstrahlcharakteristik kann beispielsweise dadurch erreicht werden, dass im Innenbereich die Höhenstrukturierung (Krümmung) der lichtlenkenden optischen Mittel eine andere Form annimmt als im Außenbereich. Um den Bereich um die Lichtabstrahlfläche der Leuchte aufzuhellen, kann der Randbereich der Leuchte eine möglichst asymmetrische Lichtabstrahlcharakteristik (Typ IIb) aufweisen, wobei das Licht möglichst in Außenrichtung, vom Innenbereich wegweisend, gelenkt wird (d.h., die keulenförmige Lichtverteilungskurve in Abb 2e zeigt nach aussen). Damit wird für den Betrachter ein möglichst angenehmer und homogener Übergang zwischen Lichtaustrittsfläche der Leuchte und der Umgebung der Leuchte erzielt. Die Lichtabstrahlcharakteristik im Innenbereich und im Außenbereich ist vorzugsweise getrennt voneinander kontrollierbar, was beispielsweise dadurch ermöglicht wird, dass die jeweiligen Elektrodenteilbereiche im Innenbereich und im Außenbereich separat angesteuert werden. Dadurch wird ein Wechsel zwischen verschiedenen Lichtatmosphären, gekennzeichnet durch einen kontrastreichen, harten Übergang zwischen Leuchte und Umgebung bzw einen sanften, milden Übergang, ermöglicht. Auch in diesem Fall allerdings wird - bei entsprechend feiner Strukturierung der Elektroden - der Effekt erzielt, dass trotz der Möglichkeit der Änderung der Lichtabstrahlcharakteristik während des Betriebs sich für einen Betrachter jederzeit der Eindruck einer flächig lichtabstrahlenden Leuchte ergibt.

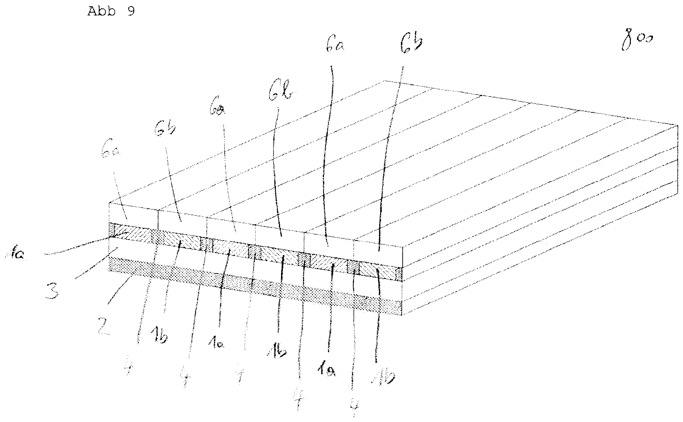

In den Ausführungsbeispielen von Abb 3 bis Abb 8 wird die Lichtlenkung durch geeignet strukturierte lichtbrechende optische Elemente erzielt. Die Strukturierung erfolgt dabei über die Höhenstrukturierung in z-Richtung (unterschiedliche Krümmung der Lichtaustrittsfläche). Es sind aber auch andere Möglichkeiten denkbar. In der lichtemittierenden Vorrichtung 800 in Abb 9 sind die lichtlenkenden optischen Mittel durch streifenförmige erste Bereiche 6a und streifenförmige zweite Bereiche 6b strukturiert, wobei sich die streifenförmigen ersten und zweiten Bereiche 6a und 6b hinsichtlich ihrer Brechungszahl unterscheiden. Optional können die lichtlenkenden optischen Mittel eine zusätzliche Höhenstrukturierung in z-Richtung aufweisen.

Lichtlenkung kann auch durch Beugung erreicht werden. Dazu muss eine geeignete Strukturierung der lichtlenkenden optischen Mittel in der Größenordung der Wellenlänge des emittierten Lichts erfolgen.

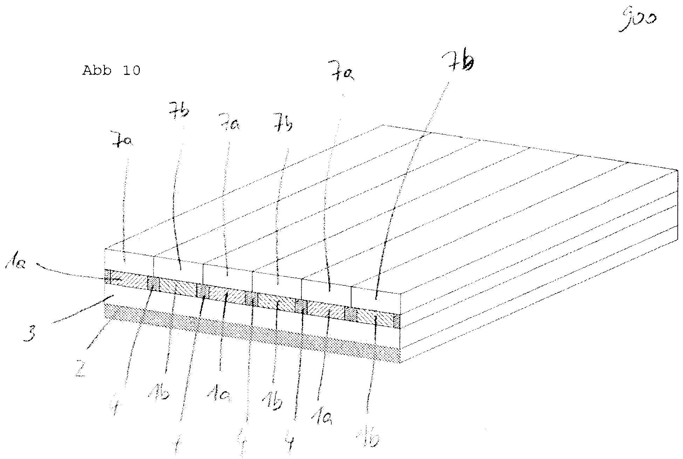

Alternativ kann die Lichtabstrahlcharakteristik durch geeignete Strukturierung der lichtlenkenden optischen Mittel in Teilbereiche gezielt beeinflusst werden, wobei die Teilbereiche ein unterschiedliches Streuverhalten zeigen. Abb 10 zeigt eine weitere lichtemittierende Vorrichtung 900, bei der analog zu Abb 9 die lichtlenkenden optischen Mittel in erste Teilbereiche 7a und zweite Teilbereiche 7b strukturiert sind. Innerhalb der ersten Teilbereiche 7a und/oder der zweiten Teilbereiche 7b sind Streupartikel angeordnet. Typischerweise ist die Größe der einzelnen Streupartikel in der Größenordnung von einigen Mikrometern bis einigen 10 Mikrometern. Einzelne Streupartikel können Licht isotrop streuen, sie können aber auch ein anisotropes Streuverhalten bewirken. Ein anisotropes Streuverhalten eines Materials kann erzielt werden, wenn anisotrope Streupartikel während des Herstellungsprozesses ausgerichtet werden, beispielsweise durch ein extern angelegtes elektrisches und/oder magnetisches Feld, welches die Streupartikel in eine bestimmte Vorzugsrichtung ausrichtet.

Erfindungsgemäß unterscheidet sich nun das Streuverhalten der beiden ersten und zweiten Teilbereiche 7a und 7b. Ein unterschiedliches Streuverhalten in beiden ersten und zweiten Teilbereichen 7a und 7b kann beispielsweise dadurch erzielt werden, dass ein Teilbereich isotropes Streuverhalten zeigt, während der andere Teilbereich ein anisotropes Streuverhalten aufweist. Es können aber auch beide Teilbereiche anisotropes Streuverhalten aufweisen, die anisotropen Streupartikeln sind dabei in beiden Teilbereichen entlang unterschiedlicher Richtungen ausgerichtet.

In den bisherigen Ausführungsbeispielen ist/sind die Elektrode (n) in streifenförmige Teilbereiche unterteilt, die im Wesentlichen parallel angeordnet sind. Insbesondere für Leuchten mit einer elliptisch-flächigen oder kreisscheibenförmigen Abstrahlfläche ist es denkbar, dass eine Elektrode in konzentrische, kreisringscheibenförmige Teilbereiche strukturiert ist. Analog wie bei den obigen Ausführungsbeispielen können die Elektrodenteilbereiche alternierend in Gruppen (1a und 1b) zusammengefasst und angesteuert werden. In ebenso analoger Weise ist die Strukturierung der lichtlenkenden optischen Mittel an die Elektrodenstrukturierung angepasst. Durch geeignete Ansteuerung der Elektrodenteilbereiche ist eine variable Lichtabstrahlung, von engstrahlend bis mittel- und breitstrahlend, realisierbar.

Wie eingangs bereits erwähnt kann der Bereich zwischen den beiden ersten und zweiten Elektroden 1 und 2 mehrere verschiedenen Schichten aufweisen, i.e. in z-Richtung strukturiert sein. In den bisherig vorgestellten Ausführungsbeispielen ist die mindestens eine, zwischen den flächigen Elektroden angeordnete, organische Materialien aufweisende lichtemittierende Schicht über die Fläche der lichtemittierenden Vorrichtung (i.e. in der xy-Ebene) gleichmäßig aufgebracht. In einem vorteilhaften Ausführungsbeispiel kann die lichtemittierende Schicht aber auch in xy-Ebene strukturiert sein.

Erfindungsgemäß können die im Bereich zwischen dem streifenförmigen Teilbereich 1a und der zweiten Elektrode 2 angeordneten optisch aktiven Moleküle ein anderes Lichtabstrahlspektrum aufweisen als die zwischen dem streifenförmigen Teilbereich 1b und der zweiten Elektrode 2 angeordneten Moleküle. Bei einer lichtemittierenden Vorrichtung, welche vorzugsweise weißes Licht abstrahlt, können die in den Teilbereichen der lichtemittierenden Schicht, welche den streifenförmigen Teilbereichen 1a zugeordnet sind, angeordneten Materialien eine andere Farbtemperatur aufweisen als die lichtemittierenden Materialien, die in den den streifenförmigen Teilbereichen 1b zugeordneten Teilbereichen der lichtemittierenden Schicht angeordnet sind.

Es sei angemerkt, dass der Inhalt der Patentansprüche, so wie sie in der ursprünglichen Fassung eingereicht wurden, Teil der Offenbarung dieser Anmeldung sein soll. Die vorliegende Erfindung jedoch wird nur durch die angehängten Patentansprüche definiert.

## Patentansprüche

1. Lichtemittierende Vorrichtung (200; 300; 400; 500; 600; 700; 800; 900), aufweisend mindestens eine flächig ausgebildete lichtemittierende Schicht (3) mit zwei gegenüberliegenden Oberflächen, eine flächig ausgebildete transparente erste Elektrode (1), die die erste Oberfläche der lichtemittierenden Schicht (3) elektrisch kontaktiert, eine flächig ausgebildete zweite Elektrode (2), die die zweite Oberfläche der lichtemittierenden Schicht (3) elektrisch kontaktiert, sowie lichtlenkende optische Mittel (5), die über der von der lichtemittierenden Schicht (3) abgewandten Oberfläche der transparenten ersten Elektrode (1) angeordnet sind, wobei mindestens eine Elektrode in mindestens zwei streifenförmige Teilbereiche (1a, 1b; 1a, 1b, 1c; 1a, 1b, 2a, 2b) strukturiert ist, welche selektiv mit elektrischer Spannung ansteuerbar sind, wobei die Ansteuerung eines streifenförmigen Teilbereichs (1a, 1b; 1a, 1b, 1c; 1a, 1b, 2a, 2b) der Elektrode Lichtemission in einem zugeordneten Teilbereich der lichtemittierenden schicht (3) bewirkt, wobei die lichtlenkenden optischen Mittel (5) strukturiert sind und das Licht aus verschiedenen Teilbereichen der lichtemittierenden Schicht unterschiedlich lenken, wobei sowohl die Strukturierung der Elektrode in streifenförmige Teilbereiche (1a, 1b; 1a, 1b, 1c; 1a, 1b, 2a, 2b) als auch die Strukturierung der lichtlenkenden optischen Mittel (5) eine Periodizität in mindestens einer Richtung aufweisen, und wobei die Strukturierung der Elektrode eine annähernd gleiche Periodizität aufweist, wie die Strukturierung der lichtlenkenden optischen Mittel (5), **gekennzeichnet dadurch, dass** sich die Strukturierung der lichtlenkenden optischen Mittel (5) über die Fläche der lichtemittierenden Vorrichtung (200; 300; 400; 500; 600; 700; 800; 900) hinweg ändert und dass sich die Strukturierung der Elektrode über die flächige Ausdehnung der lichtemittierenden Vorrichtung (200; 300; 400; 500; 600; 700; 800; 900) ändert.

2. Lichtemittierende Vorrichtung (200; 300; 400; 500; 600; 700; 800; 900) nach Anspruch 1, **gekennzeichnet dadurch, dass** die lichtlenkenden optischen Mittel (5) derart gestaltet sind, dass sich die Abstrahlcharakteristik in einem Innenbereich der lichtemittierenden Vorrichtung (200; 300; 400; 500; 600; 700; 800; 900) von der Abstrahlcharakteristik in einem Rand- oder Außenbereich unterscheidet.

3. Lichtemittierende Vorrichtung (200; 300; 400; 500; 600; 700; 800; 900) nach einem der vorangehenden Ansprüche, **gekennzeichnet dadurch, dass** sich die lichtemittierende Schicht (3) homogen über die flächige Ausdehnung der lichtemittierenden Vorrichtung (200; 300; 400; 500; 600; 700; 800; 900) erstreckt oder dass die lichtemittierende Schicht (3) über die flächige Ausdehnung der lichtemittierenden Vorrichtung (200; 300; 400; 500; 600; 700; 800; 900) eine Strukturierung aufweist.

4. Lichtemittierende Vorrichtung (200; 300; 400; 500; 600; 700; 800; 900) nach einem der vorangehenden Ansprüche, **gekennzeichnet dadurch, dass** die erste Elektrode (1), die der den lichtlenkenden optischen Mitteln (5) zugewandten Seite der lichtemittierenden Schicht (3) angeordnet ist, in streifenförmige Teilbereiche (1a, 1b; 1a, 1b, 1c) strukturiert ist.

5. Lichtemittierende Vorrichtung (200; 300; 400; 500; 600; 700; 800; 900) nach einem der vorangehenden Ansprüche, **gekennzeichnet dadurch, dass** die zweite Elektrode (2), die der den lichtlenkenden optischen Mitteln (5) abgewandten Seite der lichtemittierenden Schicht (3) angeordnet ist, in streifenförmige Teilbereiche (2a, 2b) strukturiert ist.

6. Lichtemittierende Vorrichtung (200; 300; 400; 500; 600; 700; 800; 900) nach einem der vorangehenden Ansprüche, **gekennzeichnet dadurch, dass** mindestens eine Elektrode in eine Vielzahl von streifenförmigen Teilbereichen (1a, 1b; 1a, 1b, 1c; 1a, 1b, 2a, 2b) strukturiert ist, wobei die streifenförmigen Teilbereiche (1a, 1b; 1a, 1b, 1c; 1a, 1b, 2a, 2b) in mindestens 2 Gruppen zusammengefasst sind, welche selektiv, insbesondere mit unterschiedlicher Spannung ansteuerbar sind.

7. Lichtemittierende Vorrichtung (700) nach Anspruch 6, **gekennzeichnet dadurch, dass** beide Elektroden durch eine Vielzahl von streifenförmigen Teilbereichen (1a, 1b, 2a, 2b) strukturiert sind, wobei die streifenförmigen Teilbereiche (1a, 1b, 2a, 2b) der ersten Elektrode (1), die der den lichtlenkenden optischen Mitteln (5) zugewandten Seite der lichtemittierenden Schicht (3) angeordnet ist, um 90° verdreht zu den streifenförmigen Teilbereichen der zweiten Elektrode (2), die der den lichtlenkenden optischen Mitteln (5) abgewandten Seite der lichtemittierenden Schicht (3) angeordnet ist, angeordnet sind.

8. Lichtemittierende Vorrichtung (200; 300; 400; 500; 600; 700) nach einem der vorangehenden Ansprüche, **gekennzeichnet dadurch, dass** die lichtlenkenden optischen Mittel (5) durch parallel zueinander verlaufende prismenartige Strukturen, durch halbzylinderförmige Elemente oder durch pyramiden-, halbkugel-, linsen- oder kegelförmige Elemente ausgebildet sind.

9. Lichtemittierende Vorrichtung (200; 300; 400; 500; 600; 700) nach einem der vorangehenden Ansprüche, **gekennzeichnet dadurch, dass** die lichtlenkenden optischen Mittel (5) in einer Richtung periodisch höhenstrukturiert sind, wobei vorzugsweise die Höhenstrukturierung der lichtlenkenden optischen Mittel (5) in einer Richtung linear steigend und fallend ist und die Lichtaustrittsfläche der lichtemittierenden Vorrichtung (600) im Wesentlichen plane Flächen aufweist oder die Höhenstrukturierung der lichtlenkenden optischen Mittel (5) in einer Richtung zumindest teilweise gerundet ist und die Lichtaustrittsfläche der lichtemittierenden Vorrichtung (200; 300; 400; 500; 700) gekrümmte Oberflächen aufweist.

10. Lichtemittierende Vorrichtung (800) nach einem der vorangehenden Ansprüche 1-6, **gekennzeichnet dadurch, dass** die lichtlenkenden optischen Mittel (5) in einer Richtung abwechselnd angeordnete streifenförmige erste Bereiche (6a) und streifenförmige zweite Bereiche (6b) aufweisen, wobei die streifenförmigen ersten Bereiche (6a) und die streifenförmigen zweiten Bereiche (6b) unterschiedliche Brechungszahlen aufweisen.

11. Lichtemittierende Vorrichtung (800) nach Anspruch 10, **gekennzeichnet dadurch, dass** die streifenförmigen ersten und zweiten Bereiche (6a, 6b) in jeder Richtung eine Ausdehnung aufweisen, die größer sind als eine Wellenlänge des von der lichtemittierenden Schicht (3) emittierten Lichts, wobei vorzugsweise die Breite der streifenförmigen ersten und zweiten Bereiche (6a, 6b) von der Größenordnung einer Wellenlänge des von der lichtemittierenden Schicht (3) emittierten Lichts und vorzugsweise kleiner als das 10-fache der Wellenlänge ist.

12. Lichtemittierende Vorrichtung (900) nach einem der vorangehenden Ansprüche 1-6, **gekennzeichnet dadurch, dass** die lichtlenkenden optischen Mittel (5) erste und zweite Teilbereiche (7a, 7b) aufweisen, die unterschiedliches Streuverhalten aufweisen, wobei vorzugsweise die lichtlenkenden optischen Mittel (5) in einer Richtung abwechselnd angeordnete streifenförmige erste Teilbereiche und streifenförmige zweite Teilbereiche aufweisen, und wobei ein streifenförmiges Teilbereich anisotrope Streupartikel aufweist, die entlang einer Richtung ausgerichtet sind.

13. Lichtemittierende Vorrichtung (200; 300; 400; 500; 600; 700; 800; 900) nach einem der vorangehenden Ansprüche, **gekennzeichnet dadurch, dass** die lichtlenkenden optischen Mittel (5) dazu ausgebildet sind, die Auskopplung des Lichts aus der lichtemittierenden Vorrichtung (200; 300; 400; 500; 600; 700; 800; 900) zu unterstützen.

14. Lichtemittierende Vorrichtung (200; 300; 400; 500; 600; 700; 800; 900) nach einem der vorangehenden Ansprüche, **gekennzeichnet dadurch, dass** die lichtemittierende Schicht (3) weißes Licht abstrahlt.

15. Lichtemittierende Vorrichtung (200; 300; 400; 500; 600; 700; 800; 900) nach einem der vorangehenden Ansprüche, bei der die lichtemittierende Schicht (3) ein organisches Material aufweist.

16. Beleuchtungssystem, welches mindestens eine lichtemittierende Vorrichtung (200; 300; 400; 500; 600; 700; 800; 900) nach einem der vorangehenden Ansprüche aufweist.

## Claims

1. Light-emitting device (200; 300; 400; 500; 600; 700; 800; 900) comprising at least one planar light-emitting layer (3) having two opposite surfaces, a planar transparent first electrode (1), which is in electrical contact with the first surface of the light-emitting layer (3), a planar second electrode (2), which is in electrical contact with the second surface of the light-emitting layer (3), and light-directing optical means (5), which are disposed above the surface of the transparent first electrode (1) facing away from the light-emitting layer (3),
wherein at least one electrode is structured in at least two strip-shaped subregions (1a, 1b; 1a, 1b, 1c; 1a, 1b, 2a, 2b) which can be selectively actuated with electric voltage, wherein the actuation of a strip-shaped subregion (1a, 1b; 1a, 1b, 1c; 1a, 1b, 2a, 2b) of the electrode effects the emission of light in an associated subregion of the light-emitting layer (3), wherein the light-directing optical means (5) are structured and deflect the light from different subregions of the light-emitting layer differently,
wherein both the structuring of the electrode in strip-shaped subregions (1a, 1b; 1a, 1b, 1c; 1a, 1b, 2a, 2b) and the structuring of the light-directing optical means (5) comprise a periodicity in at least one direction,
and wherein the structuring of the electrode comprises approximately the same periodicity as the structuring of the light-directing optical means (5),
**characterized in that** the structuring of the light-directing optical means (5) changes across the surface of the light-emitting device (200; 300; 400; 500; 600; 700; 800; 900) and that the structuring of the electrode changes across the planar extension of the light-emitting device (200; 300; 400; 500; 600; 700; 800; 900) .

2. Light-emitting device (200; 300; 400; 500; 600; 700; 800; 900) according to Claim 1, **characterized in that** the light-directing optical means (5) are configured in such a way that the emission characteristics in an inner region of the light-emitting device (200; 300; 400; 500; 600; 700; 800; 900) differ from the emission characteristics in an edge or outer region.

3. Light-emitting device (200; 300; 400; 500; 600; 700; 800; 900) according to any one of the preceding Claims, **characterized in that** the light-emitting layer (3) extends homogeneously across the planar extension of the light-emitting device (200; 300; 400; 500; 600; 700; 800; 900) or that the light-emitting layer (3) comprises a structure across the planar extension of the light-emitting device (200; 300; 400; 500; 600; 700; 800; 900).

4. Light-emitting device (200; 300; 400; 500; 600; 700; 800; 900) according to any one of the preceding Claims, **characterized in that** the first electrode (1), which is disposed on the side of the light-emitting layer (3) facing the light-directing optical means (5), is structured in strip-shaped subregions (1a, 1b; 1a, 1b, 1c).

5. Light-emitting device (200; 300; 400; 500; 600; 700; 800; 900) according to any one of the preceding Claims, **characterized in that** the second electrode (2), which is disposed on the side of the light-emitting layer (3) facing away from the light-directing optical means (5), is structured in strip-shaped subregions (2a, 2b) .

6. Light-emitting device (200; 300; 400; 500; 600; 700; 800; 900) according to any one of the preceding Claims, **characterized in that** at least one electrode is structured in a plurality of strip-shaped subregions (1a, 1b; 1a, 1b, 1c; 1a, 1b, 2a, 2b), wherein the strip-shaped subregions (1a, 1b; 1a, 1b, 1c; 1a, 1b, 2a, 2b) are combined into at least two groups which can be actuated selectively, in particular with a different voltage.

7. Light-emitting device (700) according to Claim 6, **characterized in that** both electrodes are structured with a plurality of strip-shaped subregions (1a, 1b; 2a, 2b), wherein the strip-shaped subregions (1a, 1b; 2a, 2b) of the first electrode (1), which is disposed on the side of the light-emitting layer (3) facing the light-directing optical means (5), are arranged rotated 90° with respect to the strip-shaped subregions of the second electrode (2), which is disposed on the side of the light-emitting layer (3) facing away from the light-directing optical means (5).

8. Light-emitting device (200; 300; 400; 500; 600; 700) according to any one of the preceding Claims, **characterized in that** the light-directing optical means (5) are formed by prism-like structures which extend parallel to one another, by semicylindrical elements or by pyramidal, semi-spherical, lenticular or conical elements.

9. Light-emitting device (200; 300; 400; 500; 600; 700) according to any one of the preceding Claims, **characterized in that** the light-directing optical means (5) are periodically structured in one direction with respect to height, wherein the height structuring of the light-directing optical means (5) preferably increases and decreases linearly in one direction and the light exit surface of the light-emitting device (600) has substantially planar surfaces or the height structuring of the light-directing optical means (5) is at least partially rounded in one direction and the light exit surface of the light-emitting device (200; 300; 400; 500; 700) has curved surfaces.

10. Light-emitting device (800) according to any one of the preceding Claims 1 - 6, **characterized in that** the light-directing optical means (5) comprise strip-shaped first regions (6a) and strip-shaped second regions (6b) which are arranged to alternate in one direction, wherein the strip-shaped first regions (6a) and the second strip-shaped second regions (6b) have different refractive indices.

11. Light-emitting device (800) according to Claim 10, **characterized in that** the strip-shaped first and second regions (6a, 6b) have an extent in each direction that is greater than a wavelength of the light emitted by the light-emitting layer (3), wherein the width of the strip-shaped first and second regions (6a, 6b) is preferably on the order of a wavelength of the light emitted by the light-emitting layer (3) and preferably less than 10 times the wavelength.

12. Light-emitting device (900) according to any one of the preceding Claims 1 - 6, **characterized in that** the light-directing optical means (5) comprise first and second subregions (7a, 7b) which exhibit different scattering behavior, wherein the light-directing optical means (5) preferably comprise strip-shaped first subregions and strip-shaped second subregions which are arranged to alternate in one direction, and wherein a strip-shaped subregion comprises anisotropic scattering particles which are aligned in one direction.

13. Light-emitting device (200; 300; 400; 500; 600; 700; 800; 900) according to any one of the preceding Claims, **characterized in that** the light-directing optical means (5) are designed to support the out-coupling of the light from the light-emitting device (200; 300; 400; 500; 600; 700; 800; 900).

14. Light-emitting device (200; 300; 400; 500; 600; 700; 800; 900) according to any one of the preceding Claims, **characterized in that** the light-emitting layer (3) emits white light.

15. Light-emitting device (200; 300; 400; 500; 600; 700; 800; 900) according to any one of the preceding Claims, in which the light-emitting layer (3) comprises an organic material.

16. Lighting system comprising at least one light-emitting device (200; 300; 400; 500; 600; 700; 800; 900) according to any one of the preceding Claims.

## Revendications

1. Dispositif d'émission de lumière (200 ; 300 ; 400 ; 500 ; 600 ; 700 ; 800 ; 900), présentant au moins une couche d'émission de lumière (3) de formation plane avec deux surfaces opposées, une première électrode transparente (1) de formation plane, qui est en contact électrique avec la première surface de la couche d'émission de lumière (3), une deuxième électrode (2) de formation plane, qui est en contact électrique avec la seconde surface de la couche d'émission de lumière (3), ainsi que des moyens optiques dirigeant la lumière (5), qui sont disposés sur la surface de la première électrode transparente (1) orientée à l'opposé de la couche d'émission de lumière (3),
dans lequel au moins une électrode est structurée en au moins deux zones partielles en forme de bandes (1a, 1b ; 1a, 1b, 1c ; 1a, 1b, 2a, 2b), qui peuvent être commandées sélectivement avec une tension électrique, où la commande d'une zone partielle en forme de bandes (1a, 1b ; 1a, 1b, 1c ; 1a, 1b, 2a, 2b) de l'électrode produit une émission de lumière dans une zone partielle associée de la couche d'émission de lumière (3), où les moyens optiques dirigeant la lumière (5) sont structurés et dirigent la lumière provenant de diverses zones partielles de la couche d'émission de lumière de manière différente, où,
la structuration de l'électrode dans les zones partielles en forme de bandes (1a, 1b ; 1a, 1b, 1c ; 1a, 1b, 2a, 2b) ainsi que la structuration des moyens optiques dirigeant la lumière (5) présentent une périodicité dans au moins une direction,
et où la structuration de l'électrode présente une périodicité à peu près identique à la structuration des moyens optiques dirigeant la lumière (5),
**caractérisé en ce que** la structuration des moyens optiques dirigeant la lumière (5) se modifie sur la face du dispositif d'émission de lumière (200 ; 300 ; 400 ; 500 ; 600 ; 700 ; 800 ; 900) et **en ce que** la structuration de l'électrode se modifie sur l'extension plane du dispositif d'émission de lumière (200 ; 300 ; 400 ; 500 ; 600 ; 700 ; 800 ; 900).

2. Dispositif d'émission de lumière (200 ; 300 ; 400 ; 500 ; 600 ; 700 ; 800 ; 900) selon la revendication 1, **caractérisé en ce que** les moyens optiques dirigeant la lumière (5) sont conçus de sorte que la caractéristique de rayonnement dans une zone interne du dispositif d'émission de lumière (200 ; 300 ; 400 ; 500 ; 600 ; 700 ; 800 ; 900) est différente de la caractéristique de rayonnement dans une zone de bord ou externe.

3. Dispositif d'émission de lumière (200 ; 300 ; 400 ; 500 ; 600 ; 700 ; 800 ; 900) selon l'une des revendications précédentes, **caractérisé en ce que** la couche d'émission de lumière (3) s'étend de manière homogène sur l'extension plane du dispositif d'émission de lumière (200 ; 300 ; 400 ; 500 ; 600 ; 700 ; 800 ; 900) ou **en ce que** la couche d'émission de lumière (3) présente une structuration sur l'extension plane du dispositif d'émission de lumière (200 ; 300 ; 400 ; 500 ; 600 ; 700 ; 800 ; 900) .

4. Dispositif d'émission de lumière (200 ; 300 ; 400 ; 500 ; 600 ; 700 ; 800 ; 900) selon l'une des revendications précédentes, **caractérisé en ce que** la première électrode (1), qui est disposée sur le côté tourné vers les moyens optiques dirigeant la lumière (5) de la couche d'émission de lumière (3), est structurée en zones partielles en forme de bandes (1a, 1b ; 1a, 1b, 1c).

5. Dispositif d'émission de lumière (200 ; 300 ; 400 ; 500 ; 600 ; 700 ; 800 ; 900) selon l'une des revendications précédentes, **caractérisé en ce que** la deuxième électrode (2), qui est disposée sur le côté tourné à l'opposé des moyens optiques dirigeant la lumière (5) de la couche d'émission de lumière (3), est structurée en zones partielles en forme de bandes (2a, 2b).

6. Dispositif d'émission de lumière (200 ; 300 ; 400 ; 500 ; 600 ; 700 ; 800 ; 900) selon l'une des revendications précédentes, **caractérisé en ce qu'**au moins une électrode est structurée en une pluralité de zones partielles en forme de bandes (1a, 1b ; 1a, 1b, 1c ; 1a, 1b, 2a, 2b), où les zones partielles en forme de bandes (1a, 1b ; 1a, 1b, 1c ; 1a, 1b, 2a, 2b) sont regroupées en au moins 2 groupes, qui peuvent être commandés sélectivement, notamment avec une tension différente.

7. Dispositif d'émission de lumière (700) selon la revendication 6, **caractérisé en ce que** les deux électrodes sont structurées par une pluralité de zones partielles en forme de bandes (1a, 1b, 2a, 2b), où les zones partielles en forme de bandes (1a, 1b, 2a, 2b) de la première électrode (1), qui est disposée sur le côté tourné vers les moyens optiques dirigeant la lumière (5) de la couche d'émission de lumière (3), sont disposées tournées de 90 ° par rapport aux zones partielles en forme de bandes de la deuxième électrode (2), qui est disposée sur le côté tourné à l'opposé des moyens optiques dirigeant la lumière (5) de la couche d'émission de lumière (3).

8. Dispositif d'émission de lumière (200 ; 300 ; 400 ; 500 ; 600 ; 700) selon l'une des revendications précédentes, **caractérisé en ce que** les moyens optiques dirigeant la lumière (5) sont formés par des structures prismatiques s'étendant parallèlement les unes aux autres, par des éléments en forme de demi-cylindres ou par des éléments en forme de pyramides, d'hémisphères, de lentilles ou de cônes.

9. Dispositif d'émission de lumière (200 ; 300 ; 400 ; 500 ; 600 ; 700) selon l'une des revendications précédentes, **caractérisé en ce que** les moyens optiques dirigeant la lumière (5) sont structurés en hauteur de manière périodique dans une direction, où, de préférence, la structuration en hauteur des moyens optiques dirigeant la lumière (5) est montante et descendante de façon linéaire dans une direction et la surface de sortie de la lumière du dispositif d'émission de lumière (600) présente des surfaces essentiellement planes ou la structuration en hauteur des moyens optiques dirigeant la lumière (5) est arrondie au moins partiellement dans une direction et la surface de sortie de lumière du dispositif d'émission de lumière (200 ; 300 ; 400 ; 500 ; 700) présente des surfaces courbées.

10. Dispositif d'émission de lumière (800) selon l'une des revendications précédentes 1 à 6, **caractérisé en ce que** les moyens optiques dirigeant la lumière (5) présentent des premières zones (6a) en forme de bandes et des secondes zones (6b) en forme de bandes disposées de manière alternée dans une direction, où les premières zones (6a) en forme de bandes et les secondes zones (6b) en forme de bandes présentent des indices de réfraction différents.

11. Dispositif d'émission de lumière (800) selon la revendication 10, **caractérisé en ce que** les premières et secondes zones (6a, 6b) en forme de bandes présentent dans chaque direction une extension, qui sont plus grandes qu'une longueur d'onde de la lumière émise par la couche d'émission de lumière (3), où, de préférence, la largeur des premières et secondes zones (6a, 6b) en forme de bandes est de l'ordre de grandeur d'une longueur d'onde de la lumière émise par la couche d'émission de lumière (3) et de préférence inférieure à 10 fois la longueur d'onde.

12. Dispositif d'émission de lumière (900) selon l'une des revendications précédentes 1 à 6, **caractérisé en ce que** les moyens optiques dirigeant la lumière (5) présentent des premières et secondes zones partielles (7a, 7b), qui présentent une dispersion différente, où, de préférence, les moyens optiques dirigeant la lumière (5) présentent des premières zones partielles en forme de bandes et des secondes zones partielles en forme de bandes disposées de manière alternée dans une direction et où une zone partielle en forme de bandes présente des particules de diffusion anisotropiques, qui sont dirigées le long d'une direction.

13. Dispositif d'émission de lumière (200 ; 300 ; 400 ; 500 ; 600 ; 700 ; 800 ; 900) selon l'une des revendications précédentes, **caractérisé en ce que** les moyens optiques dirigeant la lumière (5) sont conçus pour supporter le découplage de la lumière provenant du dispositif d'émission de lumière (200 ; 300 ; 400 ; 500 ; 600 ; 700 ; 800 ; 900).

14. Dispositif d'émission de lumière (200 ; 300 ; 400 ; 500 ; 600 ; 700 ; 800 ; 900) selon l'une des revendications précédentes, **caractérisé en ce que** la couche d'émission de lumière (3) émet de la lumière blanche.

15. Dispositif d'émission de lumière (200 ; 300 ; 400 ; 500 ; 600 ; 700 ; 800 ; 900) selon l'une des revendications précédentes, dans lequel la couche d'émission de lumière (3) présente un matériau organique.

16. Système d'éclairage, qui présente au moins un dispositif d'émission de lumière (200 ; 300 ; 400 ; 500 ; 600 ; 700 ; 800 ; 900) selon l'une des revendications précédentes.
